# EUROPEAN PATENT APPLICATION

(11) **EP 1 303 068 A1**
(43) Date of publication of application: **16.04.2003**
(21) Application number: 01934441.5
(22) Date of filing: 30.05.2001
(51) Int. Cl.: H04J 13/04, H04B 1/10

(54) **RADIO COMMUNICATION TERMINAL AND DEMODULATION METHOD**

(71) Applicant: MITSUBISHI DENKI KABUSHIKI KAISHA, Tokyo 100-8310 (JP)
(72) Inventor: SHIMIZU, Hirokazu c/o Mitsubishi Denki K.K., Chiyoda-ku, Tokyo 100-8310 (JP)
(74) Representative: Sajda, Wolf E., Dipl.-Phys.
(86) International application number: JP0104577
(87) International publication number: WO02100014

(57) **Abstract**

During the time when a radio mobile station is in communication with a base station at a certain frequency, when the frequency is being switched to another frequency and the reception level is being measured, AD data applied to a despreading/demodulating circuit (6) is set to "0" by an A/D output mask control portion (16). Thus, a noise component irrelevant to demodulation is prevented from being input to the despreading/demodulating circuit (6) after a local oscillation signal is output from a PLL synthesizer (4) until a stable baseband signal is output from a mixer circuit (3), so that stable demodulation is ensured.

## Description

### Technical Field

The present invention relates to radio communication terminals and demodulating methods. More particularly, the present invention relates to a radio communication terminal and a demodulating method that, at the time of frequency switching by a PLL synthesizer in a compressed mode, perform channel estimation by cutting a noise component which may degrade performance of the channel estimating operation, and perform decoding based on the estimated channel.

### Background Art

In a communication system defined in the 3^{rd} Generation Partnership Project (3GPP), various services have been made transportable to meet various demands in communications. The specifications define transmission rates supporting up to 2 Mbps.

The services range from those for consecutive data like voice and moving pictures to those for high-speed packets, and a plurality of such services are multiplexed and transmitted on one or more channels on physical layers (Physical Channels).

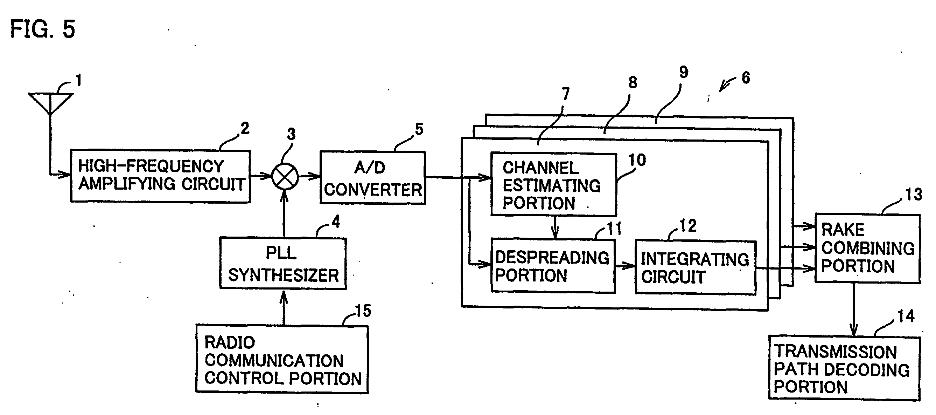

Fig. 5 is a block diagram of a receiving portion of a mobile handset in the W-CDMA system defined with the 3GPP-defined communication system. Referring to Fig. 5, a high-frequency signal received at an antenna 1 is amplified by a high-frequency amplifying circuit 2. It is then provided to a mixer 3 where it is mixed with a local oscillation signal from a PLL synthesizer 4 controlled by a radio communication control portion 17, and converted to a baseband signal. This baseband signal is converted to a digital signal by an A/D converter 5, and the digital signal is provided to a despreading/demodulating portion 6.

Despreading/demodulating portion 6 takes advantage of a high time resolution obtained by spread spectrum to despread and extract three series of incoming waves with different propagation times by respective fingers 7, 8 and 9. A rake combining portion 13 then combines the corresponding signal components in the outputs from the three fingers to improve communication quality. To this end, despreading/demodulating portion 6 includes, e.g., three fingers 7, 8 and 9. Each of fingers 7, 8 and 9 has a channel estimating portion 10, a despreading portion 11 and an integrating circuit 12. Channel estimating portion 10 estimates where a phase is for despreading the baseband signal, and fixes an axis for determination of each quadrant of QPSK. Despreading portion 11 uses a despreading code to despread the incoming waves. Integrating circuit 12 integrates the despread signal and outputs it to rake combining portion 13. Rake combining portion 13 combines the outputs of three fingers 7, 8 and 9, and provides the combined signal components to a transmission path decoding portion 14.

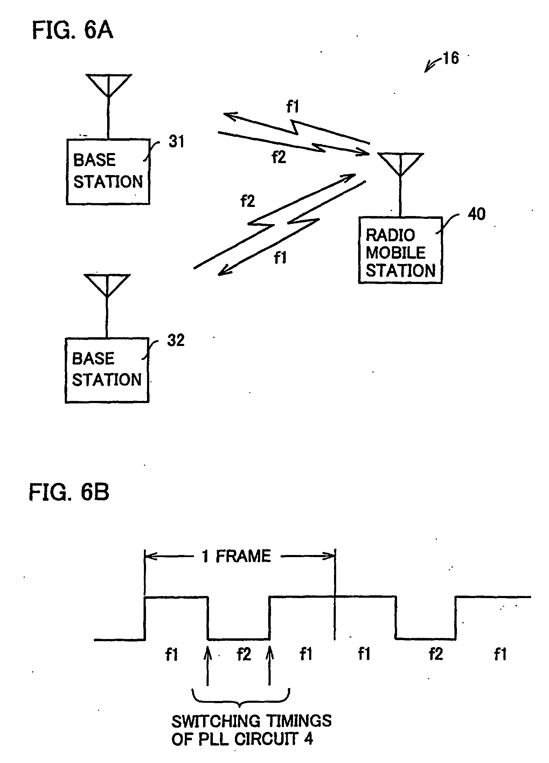

Figs. 6A and 6B show communication states between two base stations and one radio mobile station. Referring to Fig. 6A, radio mobile station 40 within a communication area of base station 31 transmits a transmission signal to base station 31 at a frequency f1 and receives a transmission signal from base station 31 at a frequency f2. At this time, radio mobile station 40 measures, at regular intervals, signal levels such as RSSI and SIR of the received signal at frequency f2 from base station 31. During the call, even though radio mobile station 40 is within the area of base station 31, it also measures, under a designation of an upper-level sequence, reception levels of base station 32 and others in the vicinity of base station 31. Further, it also needs to measure the reception levels of the base stations at different frequencies during the call. Thus, the mobile handset of the W-CDMA system is provided with a compressed mode.

In the compressed mode, as shown in Fig. 6B, control is performed such that data received during a time period within one frame where the signal is received at frequency f1 is compressed, the receiving frequency of the receiving portion is temporarily changed from frequency f1 to another frequency f2, the signal is received at frequency f2, and its reception level and the state of interference are measured.

When the receiving frequency is to be changed, a local oscillation signal generated from PLL synthesizer 4 under the control of radio communication control portion 17 shown in Fig. 5 is changed. At this time, there is a possibility that, until the local oscillation frequency is stabilized and a baseband signal based on the frequency f2 is stably output from mixer 3, a signal unusable for channel estimation by nature may enter despreading/demodulating portion 6, thereby degrading the channel estimating performance. As such, it will be better if a signal of "0" level is input, instead of the signal of the level causing degradation of the channel estimation, in which case, when the frequency is switched to a next frequency, the channel estimating operation will be started rapidly and accurately, leading to accurate and stable axis fixation.

### Disclosure of the Invention

Based on the foregoing, a main object of the present invention is to provide a radio communication terminal and a demodulating method that ensures rapid and reliable demodulation by eliminating a signal input of a noise component irrelevant to demodulation by nature.

The radio communication terminal of the present invention is provided with a receiving circuit which receives a high-frequency signal via an antenna, a local oscillator circuit which outputs a local oscillation signal of a predetermined frequency, a communication control portion which switches the frequency of the local oscillation signal output by the local oscillator circuit in response to the frequency received by the receiving circuit, a mixer circuit which mixes an output of the local oscillator circuit and the high-frequency signal received by the receiving circuit to output a baseband signal, a demodulating circuit which receives the baseband signal, performs channel estimation and demodulates the baseband signal based on the estimated channel, and a mask control portion which prevents the demodulating circuit from receiving the baseband signal and causes the demodulating circuit to receive a zero data signal for a prescribed time period immediately after the frequency switching of the local oscillation signal output by the local oscillator circuit.

As such, according to the present invention, the data being applied to the demodulating circuit until the frequency switching operation is settled is forcibly set to zero. Thus, the signal input of a noise component irrelevant to demodulation by nature can be suppressed, and malfunction of the demodulating circuit due to the noise component is minimized. Accordingly, rapid and reliable demodulation is ensured on the arrival of subsequent data for demodulation that is meaningful by nature.

Preferably, the communication control portion, in a compressed mode, temporarily switches the frequency of the local oscillation signal output by the local oscillator circuit in response to the receiving circuit temporarily receiving a high-frequency signal of a different frequency.

Still preferably, the prescribed time period controlled by the mask control portion immediately after the frequency switching of the local oscillation signal is determined based on a difference between the frequency before the switching and the frequency after the switching.

Still preferably, the prescribed time period controlled by the mask control portion immediately after the frequency switching of the local oscillation signal is determined based on an environmental temperature of the local oscillator circuit.

Another aspect of the present invention resides in the demodulating method wherein a baseband signal as a mixture of a high-frequency signal received via an antenna and a local oscillation signal of a predetermined frequency is input, channel estimation is performed and the baseband signal is demodulated based on the estimated channel. The method includes the step of performing the channel estimation with a zero data signal being input, instead of the baseband signal, during a prescribed time period immediately after frequency switching of the local oscillation signal.

As such, according to the present invention, the data being applied to a demodulating circuit until the local oscillation signal is switched and the operation of a mixer circuit is settled is forcibly set to zero. Thus, the signal input of a noise component irrelevant to the demodulation by nature is suppressed, and the demodulating circuit does not perform the channel estimating operation during the relevant time period deciding that there is no input signal. This permits rapid and reliable demodulation thereafter.

### Brief Description of the Drawings

Fig. 1 is a block diagram showing a receiving portion of an embodiment of the present invention.
Fig. 2 is a specific block diagram showing the A/D output mask control portion in Fig. 1.
Fig. 3 is a flow chart illustrating an operation of an embodiment of the present invention.
Figs. 4A-4D are time charts illustrating the operation of the embodiment of the present invention.
Fig. 5 is a block diagram showing a receiving portion of a mobile handset in a conventional W-CDMA system.
Figs. 6A and 6B show communication states between two base stations and one radio mobile station.

### Best Modes for Carrying Out the Invention

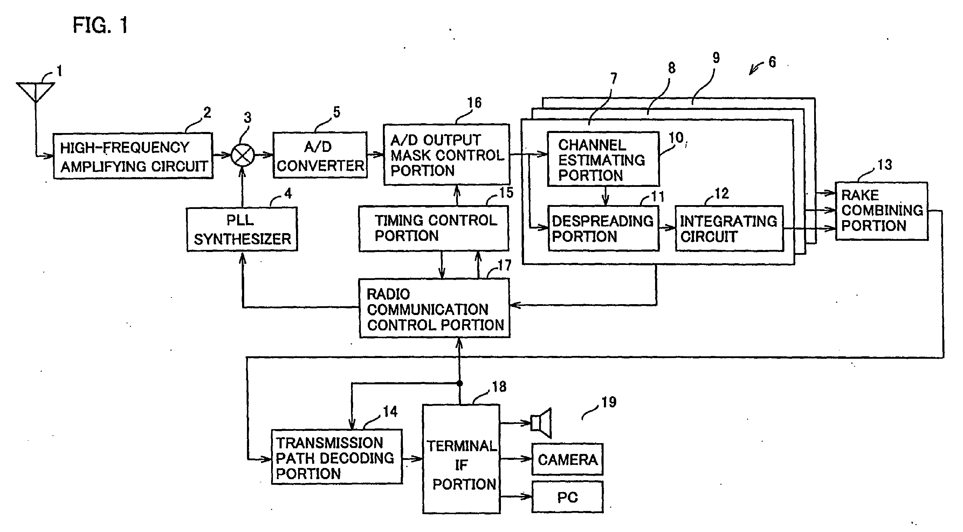

Fig. 1 is a block diagram showing the receiving portion according to an embodiment of the present invention. Referring to Fig. 1, antenna 1, high-frequency amplifying circuit 2, mixer 3, PLL synthesizer 4, A/D converter 5, despreading/demodulating portion 6, and transmission path decoding portion 14 have the same configurations as those shown in Fig. 5.

In this embodiment, an A/D output mask control portion 16 is connected between A/D converter 5 and despreading/demodulating portion 6. This A/D mask control portion 16 is provided for preventing, when a local oscillation signal is switched by PLL synthesizer 4 in a compressed mode, an output of A/D converter 5 from being input to despreading/demodulating portion 6 for a prescribed period of time. Upon estimation of a physical channel of a baseband signal by channel estimating portion 10, A/D output mask control portion 16, in response to a mask control signal applied from timing control portion 15, provides each finger 7, 8, 9 of despreading/demodulating portion 6 with a "0" code of a constant level having a relatively small influence when the channel estimating operation is invalidated. Timing control portion 15 outputs the mask control signal in response to a control signal applied from radio communication control portion 17.

Despreading/demodulating portion 6 despreads the baseband signal and outputs the resulting signal to rake combining portion 13, as described above in conjunction with Fig. 5. This demodulated output signal is applied to transmission path decoding portion 14. Transmission path decoding portion 14 performs physical format conversion, error correction including de-interleave, and error detection in a receiving system.

Radio communication control portion 17 performs protocol control for the radio communication, control of despreading/demodulation portion 6 and transmission path decoding portion 14, and communication with terminal IF portion 18. Terminal IF portion 18 serves for an interface of module 19 for a user IF such as camera, LCD or the like.

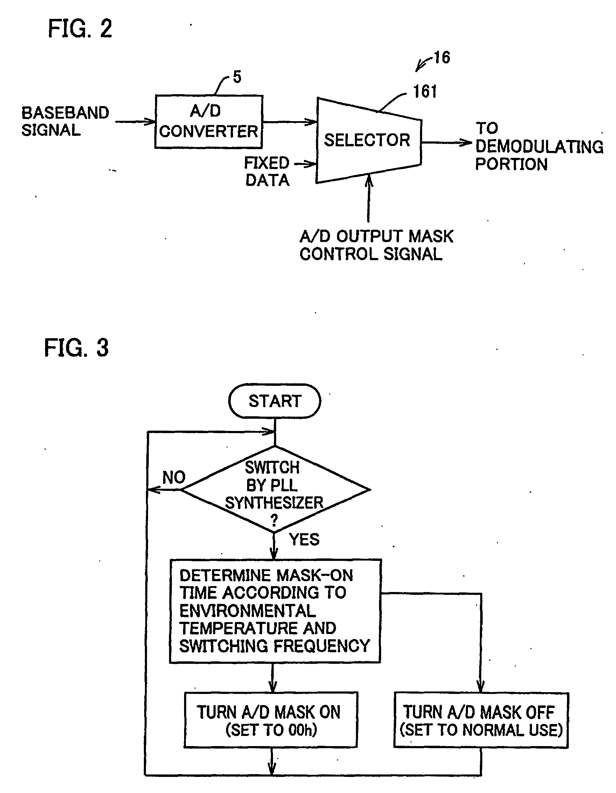

Fig. 2 is a specific block diagram of the A/D output mask control portion 16 shown in Fig. 1. A/D converter 5 shown in Fig. 1 converts the baseband signal to a digital signal, and applies it to one input of a selector 161 included in A/D output mask control portion 16. Applied to the other input of selector 161 is 00h (h indicates a hexadecimal numeral) as fixed data. This fixed data is for masking an output of A/D converter 5. Selector 161 is switched between its two inputs in accordance with the A/D output control signal output from timing control portion 15.

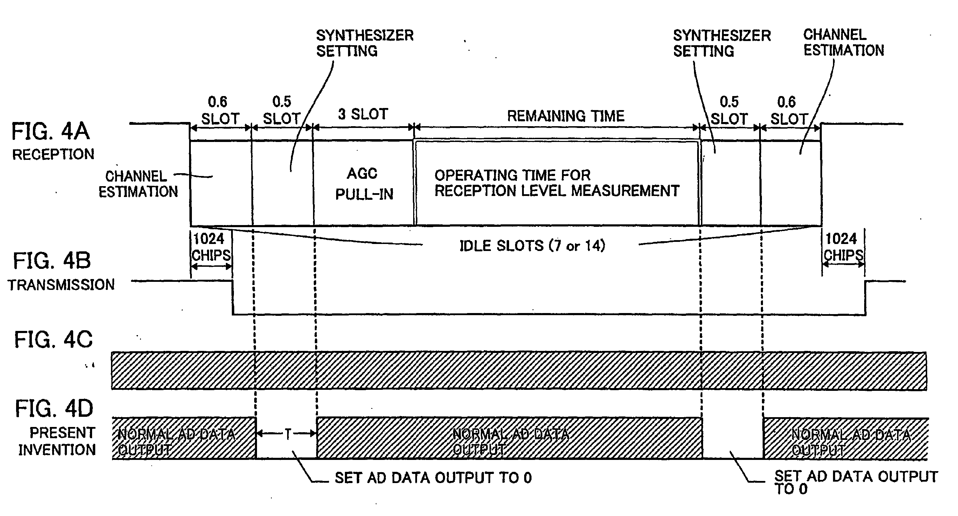

Fig. 3 and 4A-4D are a flowchart and timing charts, respectively, illustrating an operation of an embodiment of the present invention.

Hereinafter, the operation of an embodiment of the present invention is described with reference to Figs. 1 through 4A-4D. Before the receiving frequency is switched to f2, the high-frequency signal of frequency f1 received at antenna 1 is amplified by high-frequency amplifying circuit 2, and converted by mixer 3 to a baseband signal based on a local oscillation signal output from PLL synthesizer 4. This baseband signal is converted to a digital signal by A/D converter 5, and applied to A/D output mask control portion 16. Since selector 161 of A/D output mask control portion 16 is selecting the A/D converter 5 output side at this time, the baseband signal converted to the digital signal is applied to channel estimating portion 10 of despreading/demodulating portion 6.

With the frequency of f1, channel estimating portion 10 performs the channel estimation utilizing a time period of up to 0.6 slot at the timing of the received signal shown in Fig. 4A. Radio communication control portion 17, in accordance with the compressed mode sequence procedure, provides PLL synthesizer 4 with a frequency switching signal. In response, PLL synthesizer 4 provides mixer 3 with a local oscillation signal for selecting, e.g., frequency f2, so that the frequency is changed from f1 to f2.

Radio communication control portion 17 determines a mask-on time for the frequency switching of PLL synthesizer 4, according to a frequency difference before and after the switching and a surrounding environmental temperature. Thereafter, timing control portion 15 applies an A/D output mask control signal to A/D output mask control portion 16 to turn on the A/D mask. Thus, the input of selector 161 in A/D output mask control portion 16 is switched to the other input side and the fixed data is selected only for 0.5 slot period shown in Fig. 4A, with the output signal of A/D converter 5 prevented from being applied to channel estimating portion 10. That is, after the AD data applied from A/D output mask control portion 16 to despreading/demodulating portion 6 is set to "0" during the time period T of 0.5 slot shown in Fig. 4D, the input of selector 161 in A/D output mask control portion 16 is switched back to the former input side, and the baseband signal digitized by A/D converter 5 is applied to despreading/demodulating portion 6.

Mixer 3 outputs a high-frequency signal of frequency f2 in response to the local oscillation signal applied from PLL synthesizer 4. This requires approximately three slots as a pull-in time of AGC. When the high-frequency signal of frequency f2 is received, channel estimating portion 10 of despreading/demodulating portion 6 performs the channel estimating operation, and radio communication control portion 17 measures its reception level based on the output of despreading/demodulating portion 6. After a lapse of the operating time for measurement of the reception level shown in Fig. 4A, radio communication control portion 17 outputs a control signal to timing control portion 15. Radio communication control portion 17 causes PLL synthesizer 4 to output a local oscillation signal for receiving the original frequency of f1.

Further, during the time period of about 0.5 slot where the frequency is being switched, radio communication control portion 17 outputs an A/D output mask control signal to A/D mask control portion 16 to turn on an A/D mask for timing control portion 15, and switches the output of selector 161 to the fixed data "00h" side. After a lapse of the 0.5 slot period, the output of selector 161 is switched to the A/D input side, and a digitized baseband signal being the output of A/D converter 5 having received the signal of frequency f2 is applied to channel estimating portion 10. Despreading/demodulating portion 6 performs the channel estimating operation utilizing a 0.6 slot period.

Conventionally, as shown in Fig. 4C, the output of A/D converter 5 was constantly applied to despreading/demodulating portion 6, even while the local oscillation signal was being switched in PLL synthesizer 4, for measuring signal reception levels of other base stations. As such, despreading/demodulating portion 6 was likely to receive a signal unusable for the channel estimation by nature. By comparison, according to the present embodiment, the AD data applied to despreading/demodulating portion 6 is set to 0 when the local oscillation signal is switched by PLL synthesizer 4 until the operation of mixer 3 is settled, as described above. Thus, a signal input with a noise component irrelevant to demodulation by nature is suppressed, and the performance degradation due to malfunction of the channel estimating operation is minimized because the input signal to channel estimating portion 10 is regarded as none during the relevant time period. Accordingly, rapid and reliable demodulation afterwards is ensured.

In the embodiment as described above, when a frequency is being switched for measuring signal levels of other base stations, AD data being input to despreading/demodulating portion 6 has been set to "0". However, not limited thereto, the present invention is applicable to frequency switching by hard hand-over. That is, assume that, when a radio mobile station is in communication with a base station at a frequency f1, the communication is to be switched to another frequency f2. In such a case, a noise component irrelevant to demodulation by nature may be input to a despreading/demodulating circuit after a local oscillation signal is output from a local oscillator circuit until a stable baseband signal is output from a mixer. Such a problem can be solved by applying the present invention.

### Industrial Applicability

According to the present invention, during the time when a radio mobile station is in communication with a base station at a certain frequency, when the frequency is being switched to another frequency and the reception level is being measured, input data to a channel estimating portion in a demodulating circuit is set to 0. This eliminates a possibility that a noise component which may cause degradation of channel estimating performance is input after a local oscillation signal is output from a local oscillator circuit until a stable baseband signal is output from a mixer. Accordingly, the present invention is applicable to any terminal device performing radio communication like a mobile handset.

## Claims

1. A radio communication terminal, comprising:
a receiving circuit receiving a high-frequency signal via an antenna;
a local oscillator circuit outputting a local oscillation signal of a predetermined frequency;
a communication control portion switching the frequency of the local oscillation signal output from said local oscillator circuit in response to the frequency received by said receiving circuit;
a mixer circuit mixing an output of said local oscillator circuit and the high-frequency signal received by said receiving circuit to output a baseband signal;
a demodulating circuit receiving said baseband signal, performing channel estimation and demodulating said baseband signal based on the estimated channel; and
a mask control portion preventing said demodulating circuit from receiving the baseband signal and causing said demodulating circuit to receive a zero data signal for a prescribed time period immediately after the frequency switching of the local oscillation signal output by said local oscillator circuit.

2. The radio communication terminal according to claim 1, wherein in a compressed mode, said communication control portion temporarily switches the frequency of the local oscillation signal output by said local oscillator circuit in response to said receiving circuit temporarily receiving a high-frequency signal of a different frequency.

3. The radio communication terminal according to claim 1, wherein the prescribed time period controlled by said mask control portion immediately after the frequency switching of said local oscillation signal is determined based on a difference between the frequency before the switching and the frequency after the switching.

4. The radio communication terminal according to claim 1, wherein the prescribed time period controlled by said mask control portion immediately after the frequency switching of said local oscillation signal is determined based on an environmental temperature of said local oscillator circuit.

5. A demodulating method wherein a baseband signal as a mixture of a high-frequency signal received via an antenna and a local oscillation signal of a predetermined frequency is input, channel estimation is performed and said baseband signal is demodulated based on the estimated channel, comprising the step of:
performing the channel estimation by receiving a zero data signal instead of said baseband signal during a prescribed time period immediately after frequency switching of said local oscillation signal.
